# EUROPEAN PATENT APPLICATION

(11) **EP 4 835 500 A1**
(43) Date of publication of application: **04.11.2026**
(21) Application number: 24910056.1
(22) Date of filing: 23.09.2024
(51) Int. Cl.: G01R 31/00, G01R 1/44, G01R 1/36, G01R 1/02, G01R 1/04

(54) **STATE MONITORING DEVICE AND USAGE METHOD THEREFOR**

(30) Priority: 26.12.2023 CN 202311803887
(71) Applicant: Tianjin Aviation Electro-Mechanical, Tianjin 300308 (CN)
(72) Inventor: YIN, Decheng, Tianjin 300308 (CN); ZHAO, Ying, Tianjin 300308 (CN); LIU, Xin, Tianjin 300308 (CN); XU, Hui, Tianjin 300308 (CN); CHENG, Guozhu, Tianjin 300308 (CN); ZHOU, Wenliang, Tianjin 300308 (CN)
(74) Representative: Osha BWB
(86) International application number: PCT/CN2024/120375
(87) International publication number: WO 2025/139112

(57) **Abstract**

The present invention relates to an electrical product, in particular to a state monitoring device and a method of use thereof. The state monitoring device includes: a motion control component, a power control component, a position detection component, a conduction component, a support component, and a drive compensation component. The motion control component, the power control component, the position detection component, the conduction component, and the drive compensation component form the state monitoring device by means of the support component.

## Description

### TECHNICAL FIELD

The present invention relates to an electrical product, in particular to a state monitoring device and a method of using the same.

### BACKGROUND

With the continuous development of aircraft, other aeronautical vehicles, and spacecraft, the demand for improving energy conversion efficiency of associated power distribution equipment has led to increasingly stringent technical requirements, such as reducing the volume and weight of power distribution equipment and improving the reliability of electrical systems. In addition, the complex and variable application environments of such products have led to an increased demand for the products to resist vibration, noise, humidity/heat, salt spray, oil/grease, and acidic atmospheres. In addition, to enable product state monitoring, it is necessary for the product to have state monitoring functions and be able to connect and communicate with external monitoring circuits.

Patent No. CN 106356258 B provides a parallel control circuit breaker that adopts an external parallel configuration to enable parallel control of circuits. However, in this patent, the parallel control method mainly involves connecting a plurality of single-phase circuit control products in parallel outside the products to enable parallel control of circuits. With this method, the overall volume is larger than that of an internal parallel control configuration. Furthermore, the product in this patent lacks temperature compensation capability, resulting in a relatively narrow applicable temperature range that cannot satisfy the needs of variable environments. Also, the product in this patent lacks state monitoring functions and therefore cannot enable state monitoring.

Patent No. US 8008585 B2 provides a parallel control switch having a temperature compensation mechanism, a button structure, a connection assembly configured to connect the electrical switching assemblies, and a bridging device configured to connect the actuator devices. The product has temperature compensation capability, but the parallel control method is likewise based on an external parallel configuration of single-phase products. Additionally, the product in this patent also lacks state monitoring functions and therefore cannot enable state monitoring.

Patent No. CN 110931319 B provides a parallel control circuit breaker with temperature compensation capability and suitable for complex temperature environments. In addition, it adopts an internal parallel control configuration with smaller volume and weight. However, the product in this patent lacks state monitoring functions and therefore cannot enable state monitoring. Moreover, information as to whether the product satisfies performance requirements such as resistance to vibration, noise, humidity/heat, salt spray, oil/grease, and acidic atmospheres cannot be obtained from the patent text.

To improve resistance to humidity/heat, salt spray, oil/grease, and acidic atmospheres, common methods at present involve adding a protective cover or a bellows structure at the button or operating position of the product. Both approaches increase the structural complexity at the button or operating position, and the position indication is not obvious, making the product state position difficult to observe.

To improve resistance to vibration and noise of the state monitoring device, it is necessary to optimize the design of the operating structure of the product, increase the contact pressure of contacts, and improve the stability of the operating structure of the product.

In addition, to enable the product state monitoring, it is necessary to adopt a modular design approach to perform the product state monitoring, *i.e.*, an auxiliary contact function. At present, there are mainly two common position detection solutions. One mainly involves adding sensors to common electromagnetic relays, circuit breakers, or contactors to perform product position detection. The other involves adding an auxiliary contact module to the product to perform the product position detection through a mechanical auxiliary contact module approach. The approach of using sensor detection mainly involves adding relevant electronic detection mechanisms and circuits while retaining the original structure of the device, which inevitably increases the volume and weight of the product. Moreover, this design approach lacks integration and has poor structural versatility, which not only increases redundant and repetitive designs across different products but also results in a waste of design resources. The approach of using a mechanical module can achieve generalization and serialization with high reliability. However, traditional mechanical modules face difficulties in component processing and have high precision requirements for the assembly process. Therefore, it is particularly important to design a position detection module that is easy to assemble, convenient to process, and highly reliable.

### SUMMARY

Objectives of the present invention: It is particularly important to design a parallel state monitoring device that is small in volume, light in weight, highly reliable, provided with a state detection function, and having a clear state indication. Such a parallel state monitoring device is in great demand in the aviation or aerospace fields.

### Technical Solutions:

In a first aspect, a state monitoring device is provided that includes: a motion control component, a power control component, a position detection component, a conduction component, a support component, and a drive compensation component, wherein the motion control component, the power control component, the position detection component, the conduction component, and the drive compensation component form the device by means of the support component; wherein,
the motion control component is configured to control connection and disconnection between the conduction component and the power control component and provide a state indication of the device;
the power control component is configured to realize circuit conduction and power control;
the position detection component is configured to detect a position of a main contact on the conduction component to detect a device state;
the conduction component is configured to realize conduction and non-conduction of a load circuit current;
the drive compensation component is configured to control a latching position with the motion control component through synchronization of thermal deformation between the drive compensation component and the power control component;
in a closed state, the motion control component controls the conduction component and the power control component to be connected, and simultaneously the motion control component is latched with the drive compensation component, and the conduction component is separated from the position detection component, so as to enable conduction of an external load circuit; in an open state, the drive compensation component is unlatched from the motion control component, causing the conduction component and the power control component to be disconnected, so as to enable non-conduction of the external load circuit, wherein the conduction component is in contact with the position detection component, and the position detection component performs position detection of the main contact; or
in the closed state, the motion control component controls the conduction component and the power control component to be connected, and simultaneously the motion control component is latched with the drive compensation component, the conduction component is in contact with the position detection component, and the position detection component performs position detection of the main contact, so as to enable the conduction of the external load circuit; in the open state, the drive compensation component is unlatched from the motion control component, causing the conduction component and the power control component to be disconnected, so as to enable the non-conduction of the external load circuit, wherein the conduction component is disconnected from the position detection component.

In a second aspect, a method of using the state monitoring device is provided that includes:
pressing the motion control component such that the conduction component is connected with the power control component, and simultaneously the motion control component is latched with the drive compensation component, the conduction component is separated from the position detection component, and the external load circuit is in a conducting state;
when an external current exceeds a certain threshold, the power control component pushes the drive compensation component to be unlatched from the motion control component, the motion control component drives the conduction component to be separated from the power control component, the conduction component is in contact with the position detection component, and the external load circuit is in a non-conducting state.

Beneficial Effects: The state monitoring device features an integrated design that combines switching apparatus, protection apparatus, and position detection functions. Through an optimized layout of components, the weight and volume of the product are reduced. In addition, the device can achieve conduction, non-conduction, and overload protection of parallel circuits, as well as functions such as body position detection and position indication. A protective structure is creatively designed in the device to prevent liquids, gases, and micro-particles from entering the interior of the product, thereby enabling the product to be used near an engine, a gearbox, and a fuel tank. The protective mechanism of the present product also makes it suitable for marine or sand-and-dust environments. Through the temperature compensation design of the present invention, the product can be adapted for use within a wide range of temperature variations, thereby improving the stability of the product under different temperature conditions. Furthermore, the optimized design of a hinge structure in the operating structure of the present invention enables the product to meet the requirements of high-frequency service environments involving vibration and noise. By integrating the various designs described above to form the state monitoring device of the present invention, the applicable scenarios of the product are significantly expanded, and the environmental adaptability of the product is improved.

### BRIEF DESCRIPTION OF THE DRAWINGS

Other features and advantages of the present invention will be better understood from the following detailed description of preferred embodiments with reference to the accompanying drawings, in which like reference numerals denote the same or similar components.
FIG. 1 is a schematic diagram showing an overall structure of a state monitoring device in a closed state, with partial cross-section.
FIG. 2 is a schematic diagram showing an overall structure of a state monitoring device in a closed state.
FIG. 3 is an exploded view showing an overall structure of a state monitoring device.
FIG. 4 is a schematic diagram showing a mating of internal structure of a state monitoring device in an open state.
FIG. 5 is a schematic diagram showing a mating of internal structure of a state monitoring device in a closed state.
FIG. 6 is a schematic diagram showing a mating between a motion control component and a drive compensation component in a closed state.
FIG. 7 is a schematic diagram showing a mating between a motion control component and a drive compensation component in an open state.
FIG. 8 is a schematic diagram showing a mating between a conduction component and a power control component in an open state.

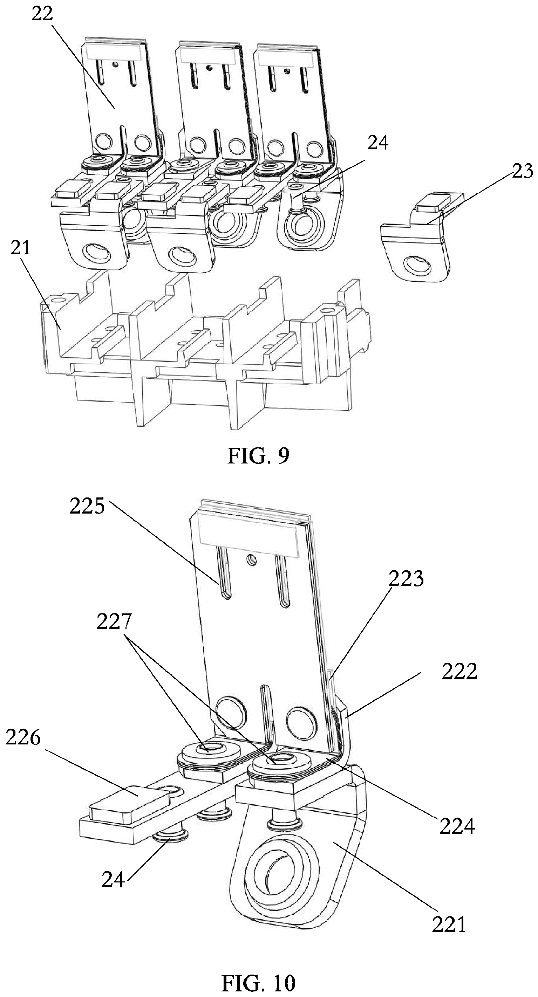

FIG. 9 is an exploded view showing a structure of a power control component.
FIG. 10 is a schematic diagram showing a structure of a sensitive element.

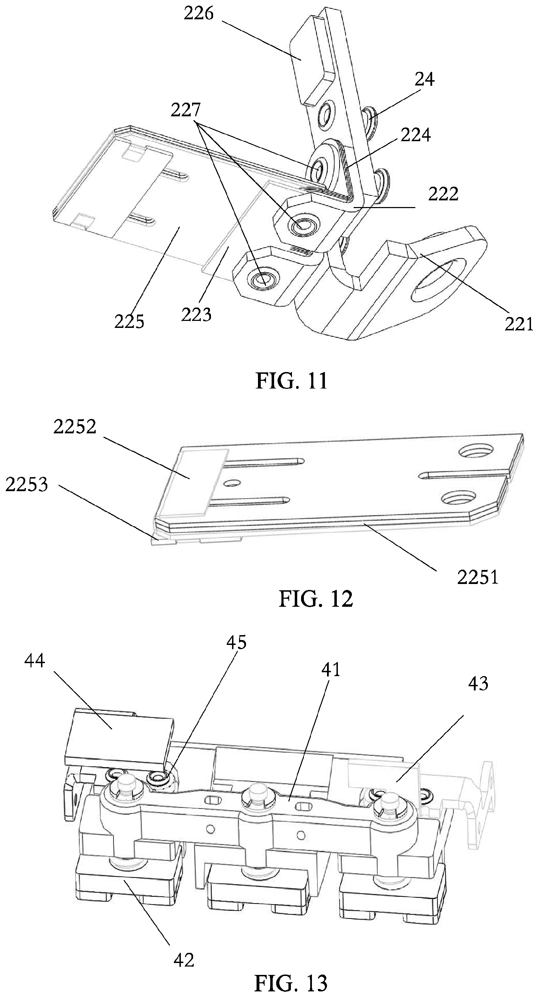

FIG. 11 is a schematic diagram showing a structure of a sensitive element.
FIG. 12 is a schematic diagram showing a structure of a bimetal component.
FIG. 13 is a schematic diagram showing a structure of a conduction component.
FIG. 14 is a schematic diagram showing a structure of a moving contact component.
FIG. 15 is a schematic diagram showing a structure of a drive compensation component.
FIG. 16 is a schematic diagram showing a structure of a latching plate.
FIG. 17 is a schematic diagram showing a mating relationship between a position detection component and a conduction component in a closed state.
FIG. 18 is a schematic diagram showing a mating relationship between a position detection component and a conduction component in an open state.
FIG. 19 is a schematic diagram showing a structure of a support component.

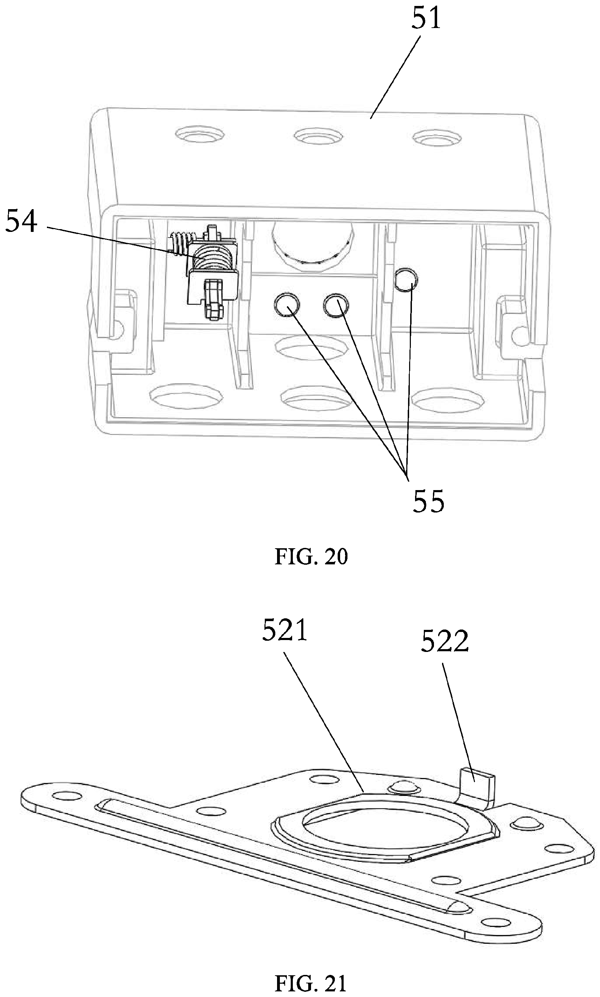

FIG. 20 is a schematic diagram showing a structure of a support component.
FIG. 21 is a schematic diagram showing a structure of a positioning sheet.
FIG. 22 is a schematic diagram showing a mating relationship between a holding mechanism and a latching support plate in a closed state.
FIG. 23 is a schematic diagram showing a mating relationship between a holding mechanism and a latching support plate in an open state.
FIG. 24 is a schematic diagram showing a structure of a holding mechanism.
FIG. 25 is a schematic diagram showing a mating of internal structure of a state monitoring device in an open state in a second logic state.

### DETAILED DESCRIPTION

To make the objectives, technical solutions, and advantages of the present invention clearer, the technical solutions of the present invention will be described clearly and completely below in junction with specific embodiments of the present invention. Obviously, the described embodiments are only a part of the embodiments of the present invention, and not all of them. All other embodiments conceived by a person skilled in the art without creative effort based on the embodiments of the present invention fall within the protection scope of the present invention.

### Specific Mode of Implementation

The implementation and use of specific embodiments of the present invention are described in detail below with reference to the accompanying drawings. However, it should be understood that the specific embodiments described merely exemplarily illustrate specific ways to implement and use the present invention, and do not limit the scope of the present invention.

A state monitoring device is provided that includes: a motion control component, a power control component, a position detection component, a conduction component, a support component, and a drive compensation component. The motion control component, the power control component, the position detection component, the conduction component, and the drive compensation component form the state monitoring device by means of the support component. The motion control component is configured to control connection and disconnection between the conduction component and the power control component and provide a state indication of the state monitoring device. The power control component is configured to realize circuit conduction and power control. The position detection component is configured to detect a position of a main contact on the conduction component to detect a device state. The conduction component is configured to realize conduction and non-conduction of a load circuit current. The drive compensation component is configured to control a latching position with the motion control component through synchronization of thermal deformation between the drive compensation component and the power control component.

For a first mating logic, in a closed state, the motion control component controls the conduction component and the power control component to be connected. Simultaneously, the motion control component is latched with the drive compensation component. The conduction component is separated from the position detection component, so as to enable conduction of an external load circuit. In an open state, the drive compensation component is unlatched from the motion control component. The motion control component moves upward, causing the conduction component and the power control component to be disconnected, so as to enable non-conduction of the external load circuit. The conduction component is in contact with the position detection component. The position detection component performs position detection of the main contact.

For a second mating logic, in the closed state, the motion control component controls the conduction component and the power control component to be connected. Simultaneously, the motion control component is latched with the drive compensation component. The conduction component is in contact with the position detection component. The position detection component performs position detection of the main contact, so as to enable the conduction of the external load circuit. In the open state, the drive compensation component is unlatched from the motion control component. The motion control component moves upward, causing the conduction component and the power control component to be disconnected, so as to enable the non-conduction of the external load circuit. The conduction component is disconnected from the position detection component.

In a specific embodiment, the motion control component is mounted in a middle portion of an inner cavity of the support component, with an upper end protruding from a central hole in an upper end surface of the support component and fixed on the support component and a lower end in contact with the conduction component to mate with the conduction component to perform a reciprocating movement and mounted on a bottom surface of the inner cavity of the support component.

In the state monitoring device, the power control component is mounted in a lower portion of the inner cavity of the support component, with an upper end extending deep into the side of the inner cavity of the support component to mate with the drive compensation component and a lower end disposed below the support component for connection to an external load circuit.

In the state monitoring device, the position detection component is mounted on a side wall of the inner cavity of the support component, with a detection end extending inward and outward relative to the side wall, respectively. The detection end extending inward mates and is in conduction with the conduction component with the reciprocating movement. The output end of the position detection component extends from the side wall of the support component and is connected to a detection circuit.

In the state monitoring device, the conduction component is mounted in the inner cavity of the support component, with an upper end mating with the motion control component and a lower end mating with the power control component with the reciprocating movement of the motion control component.

In the state monitoring device, the drive compensation component is mounted on the side of the inner cavity of the support component, with an upper end mating with the support component such that the drive compensation component is rotatable about the support component and a lower end mating with an upper portion of the power control component.

In a specific embodiment, the product adopts an internal parallel control configuration, in which the conduction component and the power control component are connected and disconnected inside the product. The motion control component controls the motion of the conduction component, thereby enabling a reduction in the volume and weight of the product. In addition, there is a position detection component inside the product that can enable product state monitoring.

The above motion control component includes a pull button, an indicator ring, a positioning sleeve, an insulating sleeve, a motion control mechanism, and a spring. The pull button is disposed at an end of the motion control component. A lower end of the pull button passes through the indicator ring, the positioning sleeve, and the insulating sleeve to be coupled with the motion control mechanism. The pull button is configured to manually control opening and closing of the entire device. The indicator ring is configured to indicate whether the device is in the closed state or the open state. The indicator ring is fixedly connected to the pull button. With the reciprocating movement of the pull button, the indicator ring is embedded into the positioning sleeve when the product is in the closed state and is exposed from the positioning sleeve when the product is in the open state. The positioning sleeve is mounted at an upper end of an upper housing and mates with the positioning sheet to define the installation position of the entire product. The insulating sleeve is mounted between the indicator ring and the positioning sleeve. The relative position between the insulating sleeve and the positioning sleeve is fixed. The insulating sleeve serves to seal and insulate the internal structure of the device from the external environment.

The requirements of the entire device for resistance to humidity/heat, salt spray, oil/grease, and acidic atmospheres can be achieved through the mutual mating of the insulating sleeve with the pull button, the indicator ring, and the positioning sleeve. The insulating sleeve can prevent external liquids, moisture, salt spray, or oil/grease particles from entering the interior of the product, thereby avoiding damage to or corrosion of the internal parts of the product.

The motion control component described above further includes a motion control mechanism that can control the conduction component and the power control component to be connected or disconnected under an action of the pull button and, when an overload current occurs in the power control component, control the conduction component and the power control component to be disconnected, control the conduction component to drive the motion control mechanism to undergo a position change. The motion control mechanism then drives the pull button and the indicator ring to undergo a position change and causes the indicator ring to be disengaged from the positioning sleeve.

The spring has one end hooked on the motion control mechanism and another end hooked on the conduction component to separate the power control component from the conduction component when the device is in the open state.

Through the above process, the product allows manual closing/opening as well as overload control of parallel circuits.

The above power control component includes a fixing base component, sensitive elements, wiring board components, and a fastening assembly. The fixing base component is configured to mount the sensitive element and the wiring board component of each phase and provide insulation between different components. The sensitive elements are uniformly distributed on an upper portion of the fixing base component to conduct multi-circuit load currents. When any one or more phases of the multi-circuit load currents exceed a certain threshold value, the sensitive element of the corresponding phase undergoes thermal deformation. The wiring board components are uniformly distributed on an upper portion of the power control component to conduct the multi-circuit load currents.

Preferably, each of the sensitive elements includes a busbar, a bent plate, a heat insulating sheet, a conductive sheet, a bimetal component, a stationary contact component, and fasteners. The busbar has one end that is provided with a threaded hole for mounting an external wire and another end that mates with the long end of the bent plate. A first fixing and mating end of the bimetal component, the conductive sheet, and the bent plate abut against one another at a bent portion to form a first integral unit, a base of which is mounted on the fixed end of the busbar. The threaded end of the busbar is provided with a threaded hole for mounting the external wire. A second fixing and mating end of the bimetal component, the conductive sheet, and the bent plate abut against one another at a bent portion to form a second integral unit, a base of which is mounted at a fixed end of the stationary contact component. The heat insulating sheet is sandwiched between a non-base position of the conductive sheet and a non-base position of the bent plate to isolate heat between the bent plate and the bimetal component. The bimetal component is configured to conduct the load current.

Further preferably, when the load current exceeds the threshold value, the bimetal component undergoes thermal deformation, with two ends of a bottom portion thereof being connected to the bent plates, respectively. The stationary contact component is configured to contact the conduction component for conduction. The fastener fixes the busbar, the bent plate, the conductive sheet, and the bimetal component together, and is also configured to fix the parts in the sensitive element to ensure the relative positions of each part.

Further preferably, each of the sensitive elements of the power control component may employ laminated bimetals of different sensitivities according to different load circuit requirements, to enable conduction and protection for different currents across a plurality of phases.

The above conduction component includes a conduction base, moving contact components, a latching support plate, a monitoring drive plate, and fasteners. The conduction base is configured to mount the moving contact component, the latching support plate, the monitoring drive plate, and the fasteners, and is driven by the motion control component to perform a reciprocating movement. The conduction base is also configured to provide insulation between the moving contact components of different phases. Each of the moving contact components is configured to contact the stationary contact component of the sensitive element and the wiring board component for the conduct and non-conduction of the load circuit current. The moving contact component is mounted on a bottom side of the conduction base. The latching support plate is configured to mate with the support component to provide a rapid connection effect for the conduction component and the power control component and enable a relative fixed position of the conduction component within the support component. The latching support plate is mounted at an upper end of the conduction base on a side opposite to the moving contact component.

Further preferably, the monitoring drive plate is configured to mate with the position detection component to drive or conduct a monitoring device in the position detection component, so as to enable position monitoring of the conduction component. The monitoring drive plate is mounted at the upper end of the conduction base on an opposite side.

Preferably, the moving contact component includes a moving wiring sheet (421), moving contacts (422), a motion axis (423), a second spring (424), and a limiting ring (425). The moving wiring sheet is configured to transmit the conduction current of the moving contacts at both ends and fix the position of the moving contacts and can move up and down along the motion axis. The moving contacts are mounted at a bottom portion of the moving contact component. The motion axis mounts the entire moving contact component at a specified position on the conduction base. The second spring is configured to provide contact pressure between the moving contact component and the stationary contact component as well as the wiring board component. The motion axis passes through a middle portion of the second spring. One end of the second spring mates with the moving wiring sheet and the conduction base. The limiting ring is configured to define a position of the motion axis on the conduction base.

The above drive compensation component includes an installation base (61), a compensation bimetal (62), calibration spring sheets (63), a latching plate (64), adjustment screws (65), rivets (66), and a spring sheet (67). The installation base is configured to mount the compensation bimetal, the calibration spring sheet, the latching plate, and the spring sheet, and to transmit forces among the parts. The compensation bimetal is configured to perform temperature compensation for the product. When a temperature of the product changes, the compensation bimetal undergoes a shape change to alter a mating relationship between the drive compensation component and the bimetal component of the sensitive elements of outer phases. The compensation bimetal is mounted on each side of both ends of the installation base. The calibration spring sheet is configured to adjust a position of the compensation bimetal to avoid excessive deformation of the compensation bimetal. The spring sheet is configured to limit excessive deformation of the latching plate and control a position of the entire drive compensation component to ensure a mating relationship of the drive compensation component with the power control component and the motion control component. The spring sheet is mounted between the latching plate and the mating end of the bimetal component as well as the installation base. The adjustment screws are respectively mounted at the ends of the compensation bimetal and the latching plate to adjust the mating gap between the compensation bimetal/the latching plate and the sensitive elements.

Preferably, the latching plate has an inverted "U" shaped structure, with an upper middle portion mounted on the installation base, a latching end mating with the motion control component, and a temperature control end mating with the bimetal component of the middle phase and configured to realize temperature compensation of the product. The temperature control end undergoes a shape change when the temperature of the product changes to alter a mating relationship between the drive compensation component and the bimetal component of the sensitive element of the middle phase.

Further preferably, the compensation bimetal and the latching plate of the drive compensation component have a temperature compensation function. When the environment in which the product is used changes, the mating relationship between these two parts and the power control component of the product is configured to adjust the deformation of the bimetal component of the power control component caused by the temperature change, thereby improving the reliability and stability of the product as a whole under different temperature conditions.

When an ambient temperature around the product increases, the sensitive elements are bent and deformed due to a temperature rise to apply a rotational force to the drive compensation component. Simultaneously, the compensation bimetal and the latching plate also undergo reverse deformation, giving the power control component a counter-force. The counter-force offsets or partially offsets the rotational force, thereby reducing the unlatching amount between the motion control mechanism and the latching end caused by the rotational force, such that a latching amount is maintained within a certain range.

When the ambient temperature around the device decreases, the sensitive elements are bent and deformed reversely due to a temperature drop to reduce the rotational force applied to the drive compensation component. Correspondingly, the counter-force applied to the power control component by the compensation bimetal and the latching plate also decreases, such that a contact force between the power control component and the drive compensation component is reduced. The calibration spring sheet and the spring sheet will, under their respective restorative forces, apply a compensation force for the counter-force to the compensation bimetal and the latching plate, thereby reducing the unlatching amount between the motion control mechanism and the latching end caused by the rotational force, such that the latching amount is maintained within a certain range.

In the present invention, the position detection component may adopt a spring probe structure that includes a base seat (31A), probes (32A), and a standard part (33A). Each of the probes is fixed on the base seat, and has one end that extends from the base seat and is connected to the standard part and another end that extends from the base seat to mate with the monitoring drive plate. When the monitoring drive plate is in contact with the two probes, the position detection component is closed. When the monitoring drive plate is separated from the two probes, the position detection component is open.

In the present invention, the structure of the position detection component is not limited to a spring probe structure or a micro-switch structure. Those skilled in the art may make various changes and improvements to various features and combinations of features not explicitly shown herein.

The above support component includes an upper housing, a positioning sheet, an insulating sheet, a holding mechanism, and fasteners. The upper housing is configured to mount internal mating parts in the product and disposed in a middle portion of the entire product. The positioning sheet is configured to define an installation position of the entire product and mounted on an upper end surface of the upper housing. The insulating sheet is configured to insulate the positioning sheet from the entire product and mounted between the positioning sheet and the upper housing. The holding mechanism is configured to control a closing process of the product, so as to ensure quick closing to prevent arcing between contacts during a slow closing process, and is mounted on an inner side of the upper housing.

Preferably, the positioning sheet contains an installation hole and a positioning pin. The installation hole is disposed in a middle portion of the positioning sheet and is configured to install the motion control component to maintain a relative position of the motion control component in the product. The positioning pin is configured to define a position and an orientation of the device during use and is disposed at the end of the positioning sheet.

Preferably, the holding mechanism includes a return spring, a pin shaft, and a force-applying component. The return spring provides rotational torque for the force-applying component. The pin shaft passes through the return spring and the force-applying component to fix both to an upper side inside the upper housing.

Further preferably, the force-applying component includes washers, connecting rods, a pull rod, and a spring. The spring is sleeved on a middle portion of the connecting rods and the pull rod and provides a force for position recovery and fixation of the connecting rod and the pull rod. The washers are mounted at both ends of the spring to constrain a position and pressure of the spring. The connecting rods are disposed on both sides of the pull rod, with one end mating with the pin shaft and another end mating with the latching support plate of the conduction component. The pull rod is disposed in a middle portion of the force-applying component, with one end mating with the pin shaft and another end mating with the latching support plate of the conduction component.

When the entire product is in the open state, the pull rod is latched and mated with the latching support plate, and the connecting rod is unlatched from the latching support plate.

When the entire product is in the closed state, the connecting rod is latched and mated with the latching support plate, and the pull rod is unlatched from the latching support plate.

The state monitoring device in the present invention has functions such as multi-phase circuit parallel switching, power control, position detection, and position indication. It reduces redundant structural design and use, has high overall reliability, and features small volume and light weight. Through optimized design, this device has functions such as resistance to vibration, noise, humidity/heat, salt spray, oil/grease, and acidic atmospheres, thereby meeting product applications in various complex environments.

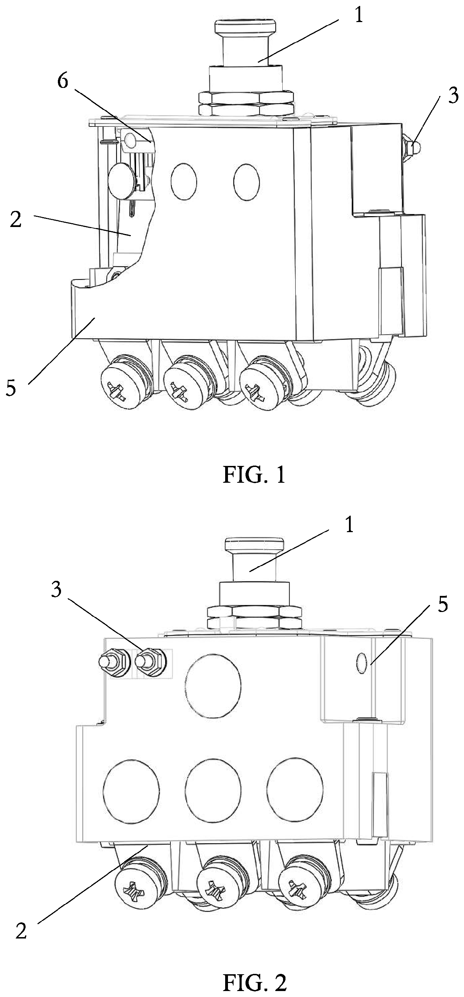

FIG. 1 shows a schematic diagram showing an overall structure of a state monitoring device in a closed state, with partial cross-section. According to an embodiment of the present invention, the state monitoring device includes: a motion control component (1), a power control component (2), a position detection component (3), a conduction component (4), a support component (5), and a drive compensation component (6). The motion control component (1), the power control component (2), the position detection component (3), the conduction component (4), and the drive compensation component (6) form the state monitoring device by means of the support component (5). The motion control component (1) is configured to control connection and disconnection between the conduction component (4) and the power control component (2) and provide a state indication of the state monitoring device. The power control component (2) is configured to realize circuit conduction and power control. The position detection component (3) is configured to detect a position of a main contact on the conduction component (4) to detect a device state.

The conduction component (4) is configured to realize conduction and non-conduction of a load circuit current. The drive compensation component (6) is configured to control a latching position with the motion control component (1) through synchronization of thermal deformation between the drive compensation component (6) and the power control component (2).

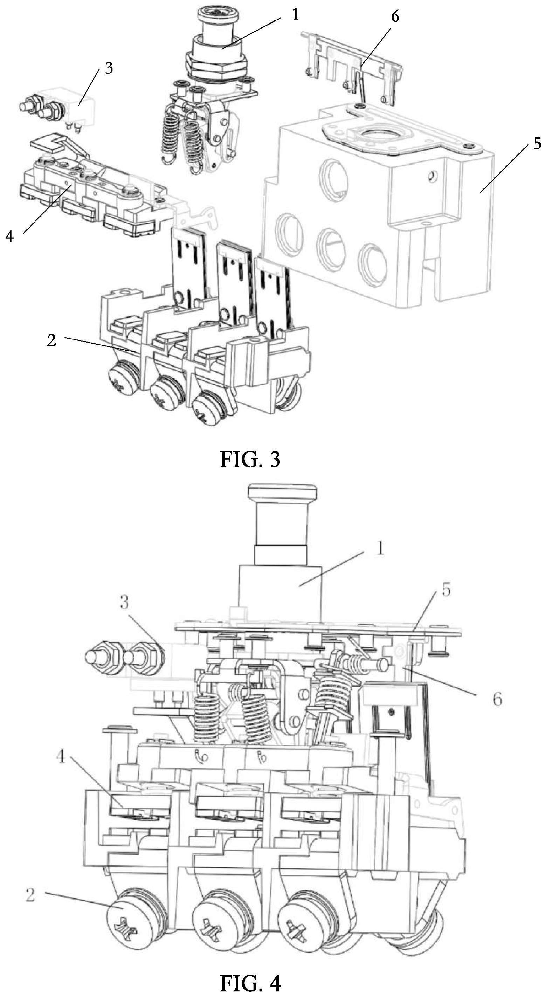

Referring to FIGs. 3-5, in this embodiment, the motion control component (1) is mounted in a middle portion of an inner cavity of the support component (5). The motion control component (1) is in contact with the conduction component (4) and mates with the conduction component (4) to perform a reciprocating movement. The power control component (2) has an upper end that extends deep into the side of the inner cavity of the support component (5) to mate with the drive compensation component (6) and a lower end that is exposed below the support component (5) for connection to the external load circuit. The position detection component (3) is mounted on a side wall of the inner cavity of the support component (5), with a detection end being in contact with or separated from the conduction component (4) with the reciprocating movement of the conduction component (4). The conduction component (4) is mounted in the inner cavity of the support component (5), with an upper end mating with the motion control component (1) and a lower end mating with the power control component (2) with the reciprocating movement of the motion control component (1). The drive compensation component (6) is mounted on the side of the inner cavity of the support component (5), with an upper end mating with the support component (5) such that the drive compensation component (6) is rotatable about the support component (5) and a lower end being in contact and mating with the power control component (2) to apply mutually opposing forces.

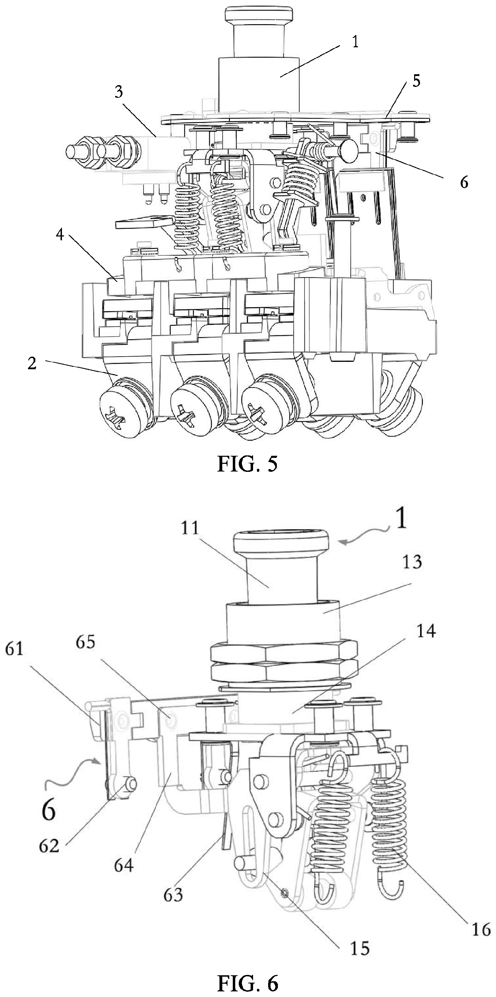

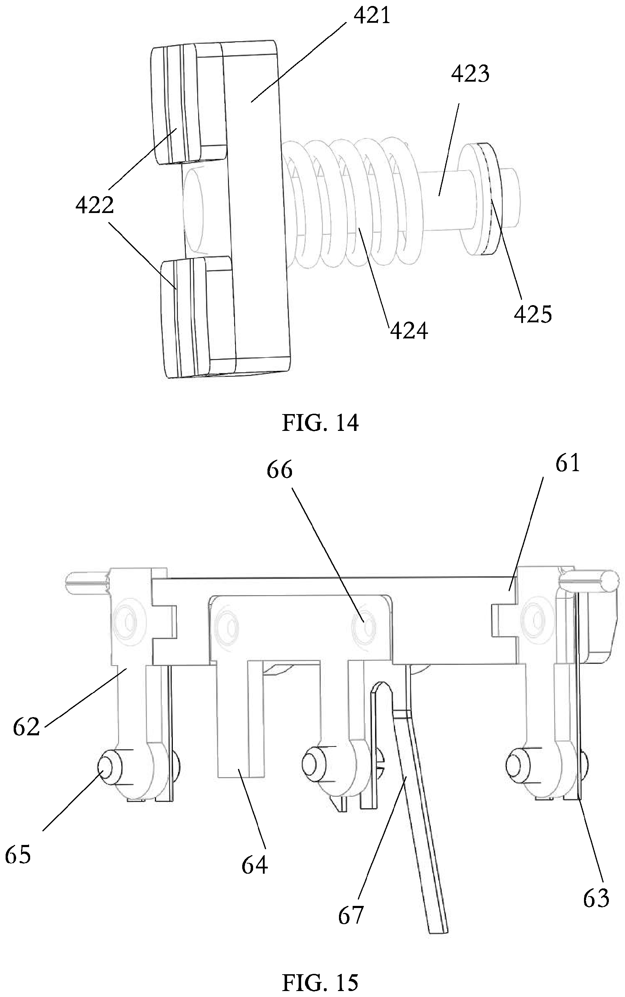

The specific operating process, as shown in FIG. 4, FIG. 7, and FIG. 8, can be summarized as follows. When the pull button (11) of the motion control component (1) is operated to move downward axially along the motion control component (1), the pull button (11) drives the motion control mechanism (15) to move downward, causing the conduction component (4) to gradually approach the power control component (2). Accordingly, the conduction component (4) mates with the holding mechanism (54) of the support component (5). The spring (5434) of the holding mechanism (54) restrains the conduction component (4) from contacting the power control component (2). When the pressure from the pull button (11) reaches a certain force value, the restraining effect of the spring (5434) of the holding mechanism (54) against the contact between the conduction component (4) and the power control component (2) fails. As shown in FIG. 1, FIG. 2, and FIG. 5, the conduction component (4) and the power control component (2) are instantaneously connected within a short time, putting the product in a closed state. Accordingly, the moving contacts (422) of each moving contact component (42) contact the stationary contact component (226) and the wiring board component (23) of the corresponding phase, respectively, as shown in FIG. 5, ensuring that the current of each phase is in the same state. Due to the mating between the motion control component (1) and the support component (5), the second spring (424) of each phase in the conduction component (4) is in a compressed state, thereby ensuring the contact pressure between the moving contacts and the stationary contacts in the device. As shown in FIG. 6, when the product is in the closed state, the motion control mechanism (15) is in contact with the bottom of the latching end (641) of the latching plate (64) of the drive compensation component (6). The relative positions of the parts in the entire motion control mechanism (15) are in a locked state, and, with the aid of the relevant mating between the compensation bimetal (62) and the upper housing (51), as shown in FIG. 15, the position of the motion control component is kept unchanged.

When the entire device is subjected to high-frequency environments such as vibration and noise, the interaction among the calibration spring sheet (63), the spring (5434), the return spring (541), and the first spring (16) of the motion control component (1) causes the relative mating position between the motion control mechanism (15) and the latching end (641) to vary within a certain range, and ensures contact between the motion control mechanism (15) and the bottom of the latching end (641), thereby ensuring the closed state of the entire device.

As shown in FIG. 5, during the closing process of the product, the heat blocking sheet (2253) of the sensitive element (22) is in contact with the adjustment screw (65), ensuring the relative stationary state between the sensitive element (22) and the drive compensation component (6).

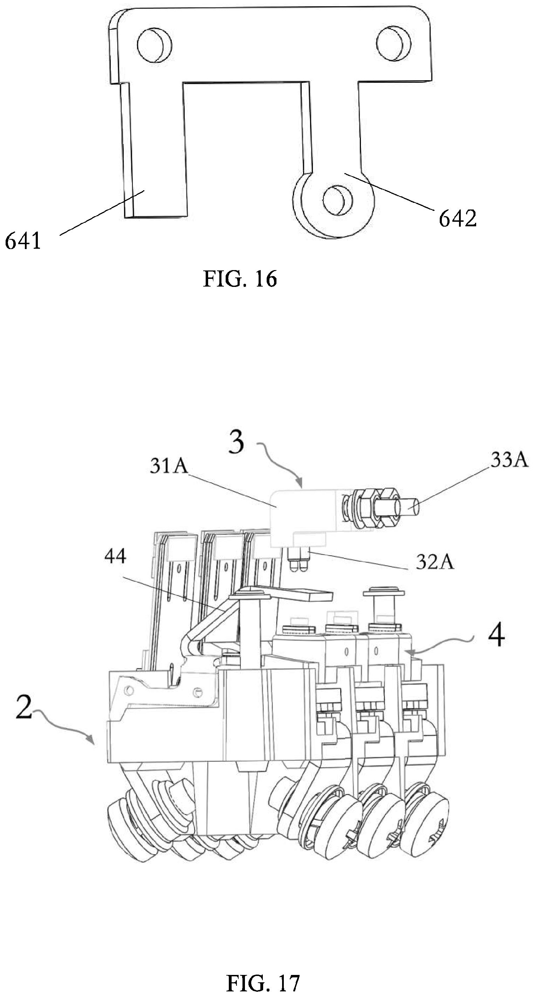

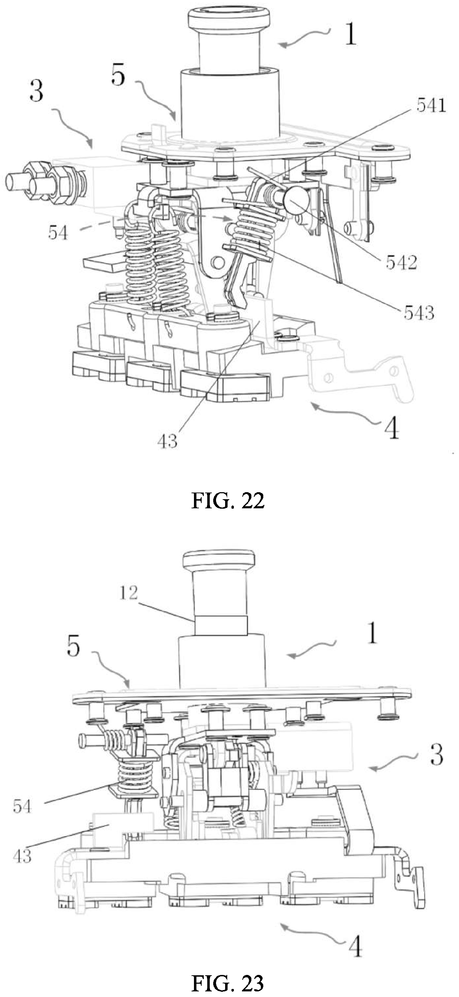

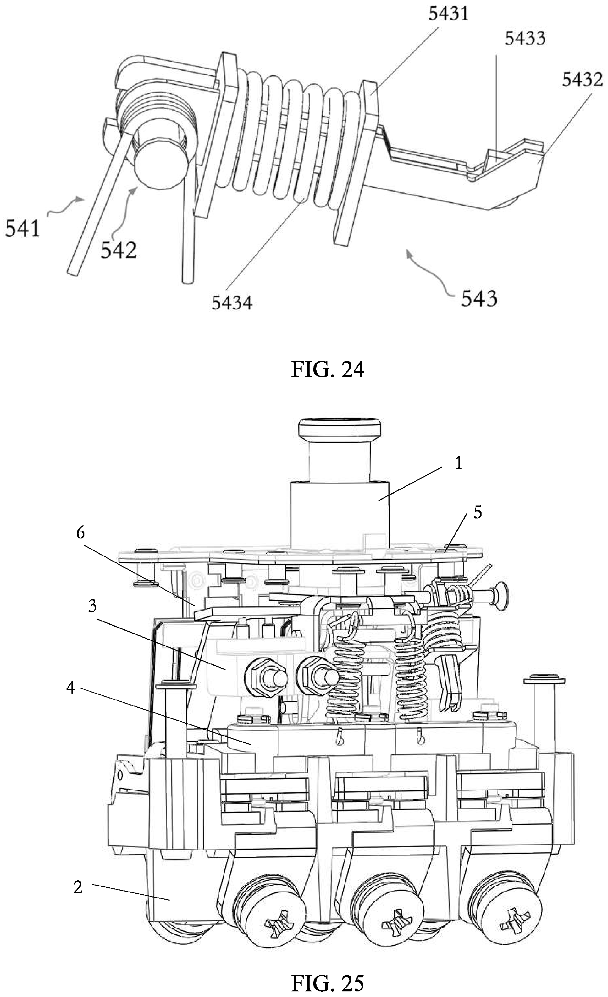

Under the first matching logic, the position detection component (3) is separated from the monitoring drive plate (44) of the conduction component (4), as shown in FIG. 5. Moreover, the indicator ring (12) is completely embedded in the positioning sleeve (13). FIG. 4, FIG. 5, FIG. 17, FIG. 18, FIG. 22, and FIG. 23 are all diagrams of the state under the first matching logic. It can be understood that in some other embodiments, namely under the second matching logic, when the conduction component (4) is connected to the power control component (2), the position detection component (3) is connected to the monitoring drive plate (44) of the conduction component (4), as shown in FIG. 25. Accordingly, the indicator ring (12) is completely embedded in the positioning sleeve (13).

The temperature compensation process of the state monitoring device of the present invention in the closed state can be summarized as follows. When the ambient temperature around the product changes, the change is specifically manifested as a decrease or increase in temperature.

Specifically, when the ambient temperature around the product increases, the sensitive elements (22) are bent and deformed due to the temperature change, thereby driving the heat blocking sheet (2253) to move toward the adjustment screw (65) and driving the adjustment screw (65) to undergo a position change. The adjustment screw (65) then drives the entire drive compensation component (6) to rotate around the upper housing (51). This type of motion would cause the relative mating position between the motion control mechanism (15) and the latching end (641) to change, reducing the latching amount between the motion control mechanism (15) and the latching end (641). In the present invention, when the sensitive elements (22) are bent and deformed due to the ambient temperature change, the compensation bimetal (62) and the latching plate (64) also undergo deformation, driving the adjustment screw (65) to press against the heat blocking sheet (2253), suppressing the reduction in the latching amount between the motion control mechanism (15) and the latching end (641) caused by the deformation of the sensitive elements (22), such that the latching amount is kept within a certain range. Therefore, the reduction in the latching amount due to the temperature change can be mitigated.

The change in force values during this process may be described as follows. When the ambient temperature around the product increases, the sensitive elements (22) are bent and deformed due to a temperature rise to apply a rotational force to the drive compensation component (6). Simultaneously, the compensation bimetal (62) and the latching plate (64) also undergo reverse deformation, giving the power control component (2) a counter-force. The counter-force offsets or partially offsets the rotational force, thereby reducing the unlatching amount between the motion control mechanism (15) and the latching end (641) caused by the rotational force.

Specifically, when the ambient temperature around the device decreases, the sensitive elements (22) are bent and deformed due to the temperature change, driving the heat blocking sheet (2253) to move away from the adjustment screw (65). Accordingly, the spring sheet (67) drives the adjustment screw (65) to fit against the heat blocking sheet (2253). The calibration spring sheet (63) and the spring sheet (67) then drive the entire drive compensation component (6) to rotate around the upper housing (51). This type of motion would cause the relative mating position between the motion control mechanism (15) and the latching end (641) to change. In the present invention, when the ambient temperature decreases, the compensation bimetal (62) and the latching plate (64) also undergo deformation, driving the adjustment screw (65) to move away from the heat blocking sheet (2253). The resulting force can partially eliminate the increase in the latching amount caused by the deformation of the spring sheet (67), such that the latching amount is kept within a certain range. Therefore, the impact of temperature reduction on the latching amount can be reduced. The fixing clip (2252) is configured to fix the laminated bimetal (2251) together with the heat blocking sheet (2253).

The change in force values during this process may be described as follows. When the ambient temperature around the product decreases, the sensitive elements (22) are bent and deformed reversely due to a temperature drop to reduce the rotational force applied to the drive compensation component (6). Correspondingly, the counter-force applied to the power control component (2) by the compensation bimetal (62) and the latching plate (64) also decreases, such that a contact force between the power control component (2) and the drive compensation component (6) is reduced. The calibration spring sheet (63) and the spring sheet (67) will, under their respective restorative forces, apply a compensation force for the counter-force to the compensation bimetal (62) and the latching plate (64).

The overcurrent protection opening process of the state monitoring device of the present invention in the closed state can be summarized as follows.

When the conducted current of any one or more phases in the product exceeds a specified amount for a certain period of time, the sensitive element (22) of each phase undergoes temperature change due to the current to be bent and deformed, which drives the heat blocking sheet (2253) to move toward the adjustment screw (65) and drives the adjustment screw (65) to undergo a position change. The adjustment screw (65) then drives the entire drive compensation component (6) to rotate around the upper housing (51). Accordingly, due to the time difference in heat transfer, the deformation occurring in the compensation bimetal (62) and the latching plate (64) is small or non-existent, such that they cannot drive the adjustment screw (65) to press against the heat blocking sheet (2253), failing to achieve the effect of suppressing the reduction in the latching amount between the motion control mechanism (15) and the latching end (641) caused by the deformation of the sensitive element (22). Accordingly, the relative mating position between the motion control mechanism (15) and the latching end (641) changes, gradually reducing the latching amount between the motion control mechanism (15) and the latching end (641) until they are unlatched, As shown in FIG. 4, FIG. 7, FIG. 8, and FIG. 18.

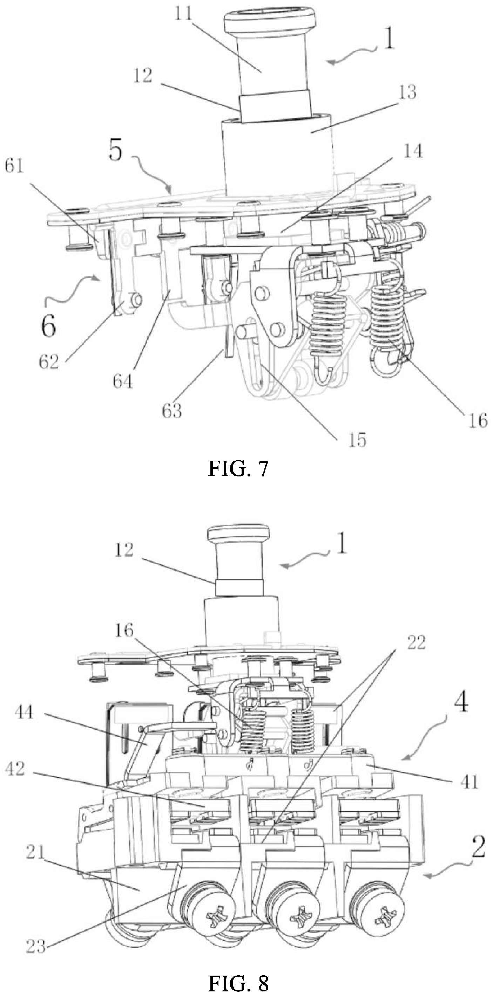

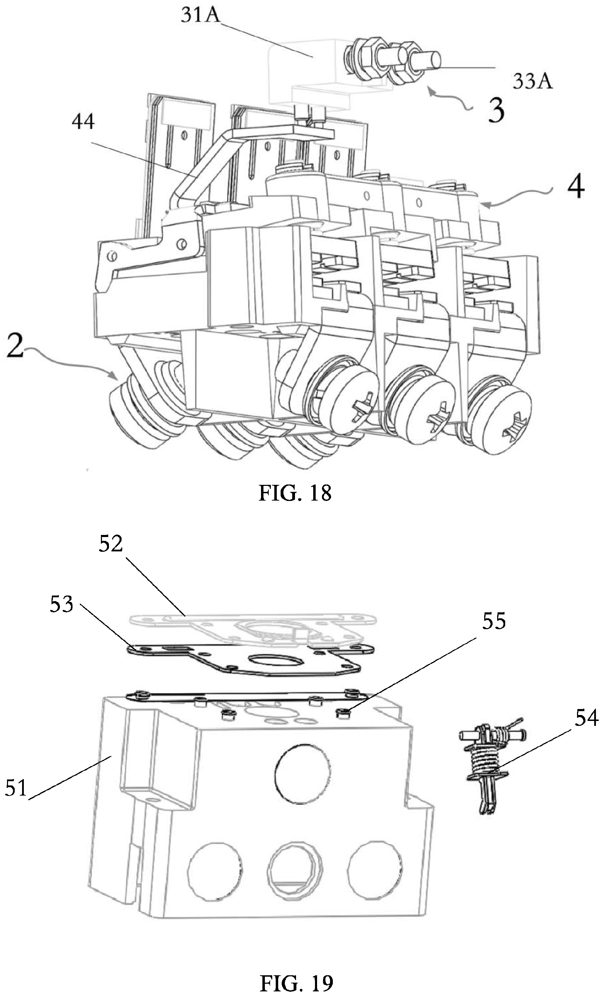

When the latching state between the motion control mechanism (15) and the latching end (641) is broken, the conduction component (4) is separated from the power control component (2), causing the product to change from the closed state to the open state. Accordingly, the moving contacts (422) of each of the moving contact components (42) are synchronously separated from the stationary contact component (226) and the wiring board component (23) of the corresponding phase, causing the multi-phase circuit to change from a conductive state to a non-conductive state, as shown in FIG. 8 and FIG. 18.

In addition, the position detection component (3) is in contact with the monitoring drive plate (44) of the conduction component (4), such that the position detection component (3) can monitor that the conduction component (4) is in the open state, as shown in FIG. 4 and FIG. 18.

Accordingly, the indicator ring (12) is disengaged axially from the positioning sleeve (13), indicating that the product is in the open state, as shown in FIG. 8.

In some embodiments, the opening process of the state monitoring device of the present invention can also be a manual opening process, specifically as follows.

When an external force pulls the pull button (11) of the motion control component (1) to move upward axially along the motion control component (1), the pull button (11) drives the motion control mechanism (15) to move upward. The relative mating position between the motion control mechanism (15) and the latching end (641) changes, reducing the latching amount between the motion control mechanism (15) and the latching end (641). The latching amount between the motion control mechanism (15) and the latching end (641) gradually reduces until they are unlatched, as shown in FIG. 7.

When the latching state between the motion control mechanism (15) and the latching end (641) is broken, the conduction component (4) is separated from the power control component (2), causing the product to change from the closed state to the open state. Accordingly, the moving contacts (422) of each of the moving contact components (42) are synchronously separated from the stationary contact component (226) and the wiring board component (23) of corresponding phase, causing the multi-phase circuit to change from a conductive state to a non-conductive state, as shown in FIG. 8 and FIG. 18.

Accordingly, the position detection component (3) is in contact with the monitoring drive plate (44) of the conduction component (4). The indicator ring (12) is disengaged axially from the positioning sleeve (13), indicating that the product is in the open state.

Preferred embodiments of the present invention are provided in the description and accompanying drawings of the present invention. However, the present invention may be embodied in many different forms and is not limited to the embodiments described herein. These embodiments are not intended to impose additional limitations on the content of the present invention; rather, they are provided to facilitate a more thorough and complete understanding of the disclosure of the present invention. Moreover, the various technical features mentioned above may be combined with one another to form various embodiments not listed above, all of which shall be deemed to fall within the scope recorded in the description of the present invention. Further, for those skilled in the art, improvements or modifications can be made according to the above description, and all such improvements and modifications should fall within the scope of the appended claims of the present invention.

## Claims

1. A state monitoring device, comprising: a motion control component (1), a power control component (2), a position detection component (3), a conduction component (4), a support component (5), and a drive compensation component (6), wherein the motion control component (1), the power control component (2), the position detection component (3), the conduction component (4), and the drive compensation component (6) form the state monitoring device by means of the support component (5); wherein,
the motion control component (1) is configured to control connection and disconnection between the conduction component (4) and the power control component (2) and provide a state indication of the state monitoring device;
the power control component (2) is configured to realize circuit conduction and power control;
the position detection component (3) is configured to detect a position of a main contact on the conduction component (4) to detect a device state;
the conduction component (4) is configured to realize conduction and non-conduction of a load circuit current;
the drive compensation component (6) is configured to control a latching position with the motion control component (1) through synchronization of thermal deformation between the drive compensation component (6) and the power control component (2);
in a closed state, the motion control component (1) controls the conduction component (4) and the power control component (2) to be connected, and simultaneously the motion control component (1) is latched with the drive compensation component (6), and the conduction component (4) is separated from the position detection component (3), so as to enable conduction of an external load circuit; in an open state, the drive compensation component (6) is unlatched from the motion control component (1), causing the conduction component (4) and the power control component (2) to be disconnected, so as to enable non-conduction of the external load circuit, wherein the conduction component (4) is in contact with the position detection component (3), and the position detection component (3) performs position detection of the main contact; or
in the closed state, the motion control component (1) controls the conduction component (4) and the power control component (2) to be connected, and simultaneously the motion control component (1) is latched with the drive compensation component (6), the conduction component (4) is in contact with the position detection component (3), and the position detection component (3) performs position detection of the main contact, so as to enable the conduction of the external load circuit; in the open state, the drive compensation component (6) is unlatched from the motion control component (1), causing the conduction component (4) and the power control component (2) to be disconnected, so as to enable the non-conduction of the external load circuit, wherein the conduction component (4) is disconnected from the position detection component (3).

2. The state monitoring device according to claim 1, wherein the motion control component (1) is mounted in a middle portion of an inner cavity of the support component (5), and the motion control component (1) is in contact with the conduction component (4) and mates with the conduction component (4) to perform a reciprocating movement; the power control component (2) has an upper end that extends deep into the side of the inner cavity of the support component (5) to mate with the drive compensation component (6) and a lower end of the power control component (2) that is exposed below the support component (5) for connection to the external load circuit; the position detection component (3) is mounted on a side wall of the inner cavity of the support component (5), with a detection end being in contact with or separated from the conduction component (4) with the reciprocating movement of the conduction component (4); the conduction component (4) is mounted in the inner cavity of the support component (5), with an upper end mating with the motion control component (1) and a lower end mating with the power control component (2) with the reciprocating movement of the motion control component (1); the drive compensation component (6) is mounted on the side of the inner cavity of the support component (5), with an upper end mating with the support component (5) such that the drive compensation component (6) is rotatable about the support component (5) and a lower end being in contact and mating with the power control component (2) to apply mutually opposing forces.

3. The state monitoring device according to claim 2, wherein a pull button (11) at an upper end of the motion control component (1) protrudes from a central hole in an upper end surface of the support component (5) and is fixed within the support component (5); a lower end of the motion control component (1) is in contact with the conduction component (4) to mate with the conduction component (4) to perform a reciprocating movement.

4. The state monitoring device according to claim 2, wherein the detection end of the position detection component (3) is in contact with the detection point of the conduction component (4), and an output end of the position detection component (3) is connected to a detection circuit.

5. The state monitoring device according to claim 3, wherein the motion control component (1) further comprises: a positioning sleeve (13), a motion control mechanism (15), and a first spring (16); wherein
the pull button (11) is disposed at the upper end of the motion control component (1), a lower end of the pull button (11) passes through the positioning sleeve (13) to be coupled with the motion control mechanism (15), and the pull button (11) is configured to manually control opening and closing of the entire device; the first spring (16) has one end that is hooked on the motion control mechanism (15) and another end that is hooked on the conduction component (4) to separate the power control component (2) from the conduction component (4) when the product is in the open state; and
the motion control mechanism (15) is configured to: automatically control the conduction component (4) and the power control component (2) to be connected or disconnected under an action of the pull button (11); simultaneously, automatically control the conduction component (4) and the power control component (2) to be disconnected when an overload current occurs in the power control component (2), and control the conduction component (4) to drive the motion control mechanism (15) to undergo a position change, such that the motion control mechanism (15) then drives the pull button (11) to move.

6. The state monitoring device according to claim 2, wherein the motion control component (1) further comprises: an indicator ring (12) and an insulating sleeve (14); wherein
the indicator ring (12) is disposed between the pull button (11) and the motion control mechanism (15) and is fixedly connected to the pull button (11) such that the indicator ring (12) reciprocates with the pull button (11); when the device is closed, the indicator ring (12) is embedded in the positioning sleeve (13), and when the device is in the open state, the indicator ring (12) protrudes from the positioning sleeve (13); the positioning sleeve (13) is mounted at an upper end of an upper housing (51), and the insulating sleeve (14) is mounted between the indicator ring (12) and the positioning sleeve (13), with the insulating sleeve (14) being relatively fixed to the positioning sleeve (13).

7. The state monitoring device according to claim 2, wherein the power control component (2) comprises sensitive elements (22), fastening assemblies (24), wiring board components (23), and a fixing base component (21); the fixing base component (21) is configured to mount the sensitive element (22) and the wiring board component (23) of each phase and provide insulation; the sensitive elements (22) are uniformly distributed on an upper portion of the power control component (2) to conduct multi-circuit load currents; when any one or more phases of the multi-circuit load currents exceed a threshold value, the sensitive element (22) of the corresponding phase undergoes thermal deformation; the wiring board components (23) are uniformly distributed on a lower portion of the power control component (2) to conduct the multi-circuit load currents.

8. The state monitoring device according to claim 7, wherein the sensitive element (22) comprises a busbar (221), a bent plate (222), a heat insulating sheet (223), a conductive sheet (224), a multi-phase bimetal component (225), a stationary contact component (226), and fasteners (227); wherein
a first fixing and mating end of the multi-phase bimetal component (225), the conductive sheet (224), and the bent plate (222) abut against one another at a bent portion to form a first integral unit, a base of which is mounted on the busbar (221); a second fixing and mating end of the bimetal component (225), the conductive sheet (224), and the bent plate (222) abut against one another at a bent portion to form a second integral unit, a base of which is mounted at a fixed end of the stationary contact component (226); the heat insulating sheet (223) is sandwiched between the conductive sheet (224) and the bent plate (222) at a non-base position to isolate heat between the bent plate (222) and the bimetal component (225); and the bimetal component (225) is configured to conduct load current.

9. The state monitoring device according to claim 8, wherein a laminated bimetal (2251) of the bimetal component (225) is composed of a plurality of bimetal sheets and deforms when temperature changes, so as to drive the drive compensation component (6) to undergo displacement; a heat blocking sheet (2253) is mounted on an upper side of the bimetal component (225) to be in contact and mate with the drive compensation component (6) for isolating heat between the bimetal component (225) and the drive compensation component (6); a fixing clip (2252) is configured to fix the laminated bimetal (2251) together with the heat blocking sheet (2253).

10. The state monitoring device according to claim 2, wherein a conduction base (41) of the conduction component (4) is equipped with moving contact components (42), a latching support plate (43), a monitoring drive plate (44), and fasteners (45), and is driven by the motion control component (1) to perform a reciprocating movement; the conduction base (41) is configured to provide insulation between the moving contact components (42) of different phases; each of the moving contact components (42) is configured to contact the stationary contact component (226) of the sensitive element (22) and the wiring board component (23) for the conduct and non-conduction of the load circuit current; the moving contact component (42) is mounted on a bottom side of the conduction base (41); the latching support plate (43) is configured to mate with the support component (5) to provide a rapid connection effect for the conduction component (4) and the power control component (2) and enable a relative fixed position of the conduction component (4) within the support component (5); the latching support plate (43) is mounted at an upper end of the conduction base (41) on a side opposite to the moving contact component (42); the monitoring drive plate (44) mates with the position detection component (3) to drive or conduct a monitoring device in the position detection component (3) to enable position monitoring of the conduction component, so as to enable position monitoring of the control device; the monitoring drive plate (44) is mounted at the upper end of the conduction base (41) on a side opposite to the latching support plate (43).

11. The state monitoring device according to claim 10, wherein moving contacts (422) of each of the moving contact components are configured to contact stationary contacts of the stationary contact component (226) and the wiring board component (23); a moving wiring sheet (421) moves up and down along a motion axis (423) under a force of a second spring (424) to enable transmission of current between the moving contacts (422) at both ends; the motion axis (423) is mounted at a specific position on the conduction base (41); a limiting ring (425) is configured to define a position of the motion axis (423) on the conduction base (41).

12. The state monitoring device according to claim 2, wherein the drive compensation component (6) comprises an installation base (61), a compensation bimetal (62), calibration spring sheets (63), a latching plate (64), and a spring sheet (67);
the installation base (61) is configured to mount the compensation bimetal (62), the calibration spring sheet (63), the latching plate (64), and the spring sheet (67), wherein the compensation bimetal (62) is mounted at both ends of the installation base (61) to perform temperature compensation for the sensitive elements (22) of outer phases of the device;
the calibration spring sheet (63) is configured to adjust a position of the compensation bimetal (62) to avoid excessive deformation of the compensation bimetal (62);
the latching plate (64) is configured to perform temperature compensation for the sensitive element (22) of a middle phase of the device, and to undergo a shape change when a temperature of the device changes to alter a mating relationship between the drive compensation component (6) and the sensitive element (22) of the middle phase, and to mate with the motion control mechanism (15) to enable latching when the device is in the closed state, wherein the latching plate (64) is mounted in a middle portion of the installation base (61);
the spring sheet (67) is configured to limit excessive deformation of the latching plate (64) and control a position of the entire drive compensation component (6) to ensure a mating relationship of the drive compensation component (6) with the power control component (2) and the motion control component (1), wherein the spring sheet (67) is mounted between the latching plate (64) and the installation base (61).

13. The state monitoring device according to claim 12, wherein the latching plate (64) has an inverted "U" shaped structure, with an upper middle portion mounted on the installation base, a latching end (641) mating with the motion control component (1) to enable latching when the device is in the closed state, and a temperature control end (642) mating with the bimetal component (225) of the middle phase and configured to realize temperature compensation of the device, wherein the temperature control end (642) undergoes a shape change when the temperature of the device changes to alter a mating relationship between the drive compensation component (6) and the bimetal component (225) of the sensitive element (22) of the middle phase.

14. The state monitoring device according to claim 2, wherein the position detection component (3) adopts a spring probe structure that comprises a base seat (31A), probes (32A), and a standard part (33A), wherein each of the probes (32A) is fixed on the base seat (31A), and has one end of the probe (32A) that extends from the base seat (31A) and is connected to the standard part, and another end that extends from the base seat (31A) to mate with the monitoring drive plate (44);
when the another end of the probe (32A) faces a lower end of the device, a mating logic between the conduction component (4) and the position detection component (3) is a first mating logic;
when the another end of the probe (32A) faces an upper end of the device, the mating logic between the conduction component (4) and the position detection component (3) is a second mating logic.

15. The state monitoring device according to claim 2, wherein the position detection component (3) adopts a micro-switch structure, and is not limited to a spring probe structure or a micro-switch structure.

16. The state monitoring device according to claim 2, wherein the support component (5) comprises an upper housing (51), a positioning sheet (52), an insulating sheet (53), a holding mechanism (54), and fasteners (55); the upper housing (51) is configured to mount internal mating parts in the device and disposed in a middle portion of the entire device; the positioning sheet (52) is configured to define an installation position of the entire device and mounted on an upper end surface of the upper housing (51); the insulating sheet (53) is configured to insulate the positioning sheet (52) from the entire device and mounted between the positioning sheet (52) and the upper housing (51); the holding mechanism (54) is configured to control a closing process of the device, so as to ensure quick closing to prevent arcing between contacts during a slow closing process, and is mounted on an inner side of the upper housing (51).

17. The state monitoring device according to claim 16, wherein the positioning sheet (52) comprises an installation hole (521) and a positioning pin (522); the installation hole (521) is disposed in a middle portion of the positioning sheet (52) and is configured to mount the motion control component (1) to maintain a relative position of the motion control component (1) in the device; the positioning pin (522) is configured to define a position and an orientation of the device during use and is disposed at the end of the positioning sheet (52).

18. The state monitoring device according to claim 17, wherein the holding mechanism (54) comprises a return spring (541), a pin shaft (542), and a force-applying component (543); the force-applying component (543) comprises washers (5431), connecting rods (5432), a pull rod (5433), and a force-applying spring (5434);
the return spring (541) provides rotational torque for the force-applying component (543), the pin shaft passes through the return spring (541) and the force-applying component (543) to fix both to an upper side inside the upper housing (51);
the force-applying spring (5434) is sleeved on a middle portion of the connecting rods (5432) and the pull rod (5433) and provides a force for position recovery and fixation of the connecting rod (5432) and the pull rod (5433); the washers (5431) are mounted at both ends of the force-applying spring (5434) to constrain a position and pressure of the spring; the connecting rods (5432) are disposed on both sides of the pull rod (5433), with one end mating with the pin shaft (542) and another end mating with the latching support plate (43) of the conduction component (4); the pull rod (5433) is disposed in a middle portion of the force-applying component (543), with one end mating with the pin shaft (542) and another end mating with the latching support plate (43) of the conduction component (4);
when the entire device is in the open state, the pull rod (5433) is latched and mated with the latching support plate (43), and the connecting rod (5432) is unlatched from the latching support plate (43);
when the entire device is in the closed state, the connecting rod (5432) is latched and mated with the latching support plate (43), and the pull rod (5433) is unlatched from the latching support plate (43).

19. A method of using the state monitoring device according to any one of claims 1-18, comprising:
pressing the motion control component (1) such that the conduction component (4) is connected with the power control component (2), and simultaneously, the motion control component (1) is latched with the drive compensation component (6), the conduction component (4) is separated from the position detection component (3), and the external load circuit is in a conducting state;
when an external current exceeds a certain threshold, the power control component (2) pushes the drive compensation component (6) to be unlatched from the motion control component (1), the motion control component (1) drives the conduction component (4) to be separated from the power control component (2), the conduction component (4) is in contact with the position detection component (3), and the external load circuit is in a non-conducting state.

20. The method according to claim 19, further comprising a step for manually opening the state monitoring device that comprises:
pulling the motion control component (1) upward, such that the drive compensation component (6) to be unlatched from the motion control component (1), thereby causing the conduction component (4) to be disconnected from the power control component (2) and enabling non-conduction of the external load circuit, wherein the conduction component (4) is in contact with or disconnected from the position detection component (3).

21. The method according to claim 19 or 20, further comprising:
when an ambient temperature around the device increases, the sensitive elements (22) are bent and deformed due to a temperature rise to apply a rotational force to the drive compensation component (6); simultaneously, the compensation bimetal (62) and the latching plate (64) also undergo reverse deformation, giving the power control component (2) a counter-force; the counter-force offsets or partially offsets the rotational force, thereby reducing the unlatching amount between the motion control mechanism (15) and the latching end (641) caused by the rotational force, such that a latching amount is maintained within a certain range;
when the ambient temperature around the device decreases, the sensitive elements (22) are bent and deformed reversely due to a temperature drop to reduce the rotational force applied to the drive compensation component (6); correspondingly, the counter-force applied to the power control component (2) by the compensation bimetal (62) and the latching plate (64) also decreases, such that a contact force between the power control component (2) and the drive compensation component (6) is reduced; the calibration spring sheet (63) and the spring sheet (67) will, under their respective restorative forces, apply a compensation force for the counter-force to the compensation bimetal (62) and the latching plate (64), thereby reducing the unlatching amount between the motion control mechanism (15) and the latching end (641) caused by the rotational force, such that the latching amount is maintained within a certain range.
